# EUROPEAN PATENT APPLICATION

(11) **EP 4 699 727 A1**
(43) Date of publication of application: **25.02.2026**
(21) Application number: 24195498.1
(22) Date of filing: 20.08.2024
(51) Int. Cl.: B23K 1/002, B23K 35/00, H01L 21/50, H01L 23/10, H01L 23/00, H01L 23/04, H01L 23/053, H01L 25/07, H01L 23/373

(54) **A SEMICONDUCOTR MODULE AND A METHOD FOR FORMING THE SAME**

(71) Applicant: Infineon Technologies AG, 85579 Neubiberg (DE)
(72) Inventor: MEIS, Lukas, 33142 Büren (DE); DREPS, Florian, 33106 Paderborn (DE)
(74) Representative: Infineon Patent Department

(57) **Abstract**

A semiconductor module comprises a metallic sheet comprising a first surface. The semiconductor module further comprises a semiconductor die coupled to the first surface of the metallic sheet. An electrically insulative housing comprises a circumferential frame, wherein the electrically insulative housing encloses the semiconductor die and at least a part of the first surface of the metallic sheet. Furthermore, a joining section of the circumferential frame is directly joined to the first surface of the metallic sheet, wherein an electrically inducible element is enclosed near the joining section of the circumferential frame.

## Description

### TECHNICAL FIELD

The present disclosure relates to a semiconductor module in particular, to forming a direct joint between a metallic sheet and an electrically insulative housing of such a semiconductor module.

### BACKGROUND

Many different applications such as automotive and industrial applications utilize semiconductor modules. Semiconductor modules may include one or more semiconductor dies arranged onto a metallic carrier by a solder joint or a sinter joint and enclosed inside a housing. The housing is mounted on the metallic carrier by glueing, or screwing. Often the glue is required to provide a sufficient sealing before the inner volume of the housing may be filled by an isolating gel to isolate and protect the semiconductor dies. An alternative process to connect a metallic component with a plastic component e.g., the housing is the so called heat stacking process in which the metallic substrate is heated above 250 C and then the plastic component is pressed onto the hot metallic substrate wherein the plastic component is partially molten at the joining section to form a solid joint when cooled. However, heating up the metallic carrier of a semiconductor module would affect the solder or sinter joints between the metallic carrier and semiconductor dies and may lead to tilting of the semiconductor dies with respect to the metallic carrier or even to detachment of the semiconductor dies from the substrate. This may lead to inefficient performance of the semiconductor module during operation or even to a defective semiconductor module during production.

There is a need for an improved way to mount and seal a housing onto a carrier of a semiconductor module.

### SUMMARY

The disclosure relates to a method for forming a direct joint between a metallic sheet and an electrically insulative housing of a semiconductor module. The method comprising arranging the electrically insulative housing comprising a circumferential frame above a first surface of the metallic sheet, wherein an electrically inducible element is enclosed near a joining section of the circumferential frame, inductively heating the electrically inducible element in the circumferential frame such that the joining section of the circumferential frame is heated above a glass transition temperature, and pressing the joining section of the circumferential frame onto the first surface of the metallic sheet such that a direct joint between the first surface of the metallic sheet and the joining section of the electrically insulative housing is formed.

The disclosure relates to a semiconductor module comprising a metallic sheet comprising a first surface. The semiconductor module further comprises a semiconductor die coupled to the first surface of the metallic sheet. An electrically insulative housing comprises a circumferential frame, wherein the electrically insulative housing encloses the semiconductor die and at least a part of the first surface of the metallic sheet. Furthermore, a joining section of the circumferential frame is directly joined to the first surface of the metallic sheet, wherein an electrically inducible element is enclosed near the joining section of the circumferential frame.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figure 1A-1E illustrate various steps involved in forming a direct joint between a circumferential frame of an electrically insulative housing and a metallic sheet of a semiconductor module.
Figure 2 illustrates a cross-section of a top-view of a circumferential frame of an electrically insulative housing comprising an electrically inducible element arranged along a circumference of the circumferential frame of the electrically insulative housing.
Figure 3 illustrates an alternate example of an electrically inducible element enclosed by a circumferential frame of an electrically insulative housing in all directions.
Figure 4 illustrates an example of an outer edge of a semiconductor module, wherein a metallic sheet of a substrate is roughened.
Figure 5 illustrates an alternate example of a semiconductor module with a housing directly mounted on a metal baseplate.
Figure 6 illustrates an alternate example of a semiconductor module with a metal baseplate comprising grooves.

### DETAILED DESCRIPTION

The examples described herein provide a semiconductor module comprising a metallic sheet, a semiconductor die and an electrically insulative frame. The semiconductor die is coupled with a first surface of the metallic sheet and enclosed inside the electrically insulative housing. The electrically insulative housing comprises a circumferential frame, wherein the circumferential frame forms a joining section at a lower end of the circumferential frame and comprises an electrically inducible element near the joining section of the circumferential frame. The joining section is directly joined to the first surface of the metallic sheet by forming a thermoplastic bond between the first surface of the metallic sheet and the circumferential frame.

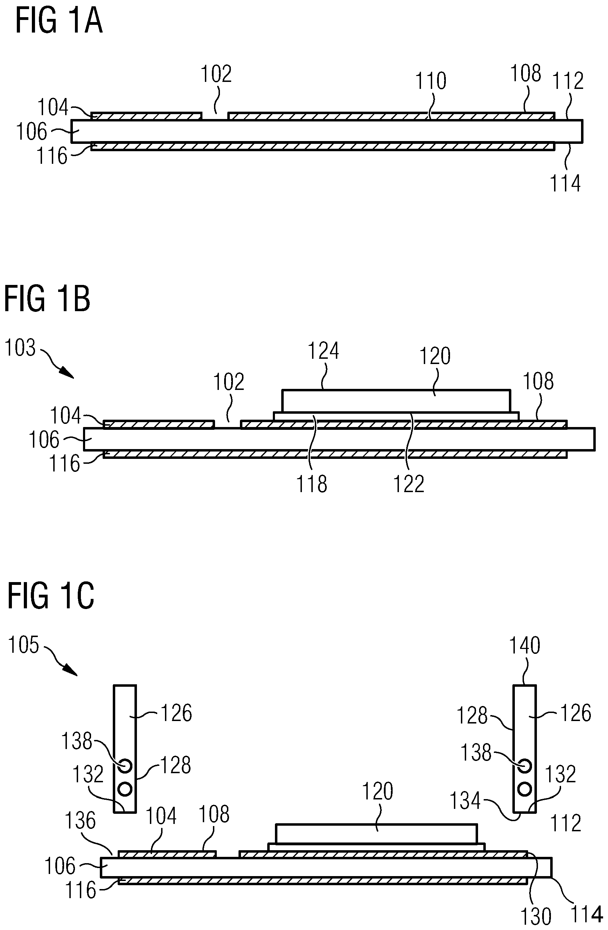

Figures 1A-1E show various steps involved in forming a direct joint between a metallic sheet 104 and an electrically insulative housing 126 of a semiconductor module 100. Figure 1A shows a substrate 102 configured to accommodate the mounting of multiple semiconductor dies thereon and to efficiently spread heat away from these semiconductor dies during operation. The substrate 102 comprises an electrically insulating sheet 106 sandwiched between two metallic sheets 104 and 116. The metallic sheet 104 is disposed on a front surface 112 of the electrically insulating sheet 106 such that a first surface 108 of the metallic sheet 104 faces away from the electrically insulating sheet 106 and a second surface 110 of the metallic sheet 104 opposite to the first surface 108 faces the electrically insulating sheet 106. The metallic sheet 104 may be structured i.e., the metallic sheet 104 may not be a continuous sheet but includes recesses between different sections or islands of the metallic sheet 104 electrically isolated from each other. The metallic sheet 116 is disposed on a back surface 114 of the electrically insulating sheet 106 opposite to the front surface 112. The metallic sheet 116 may be a continuous metallic sheet. A heat sink may be arranged on the further metallic sheet 116 for heat dissipation.

A semiconductor die 120 is mounted 103 on the substrate 102 in particular on the first surface 108 of the metallic sheet 104 as shown in Figure 1B. The semiconductor die 120 is thermally and electrically coupled to the substrate 102 by an electrically conductive layer 118 e.g., a solder layer or a sinter layer. The semiconductor die 120 has a back side 122 coupled to the first surface 108 of the metallic sheet 104 and a front side 124 opposite to the back side 122 of the semiconductor die 120. A first electrode may be arranged on the back side 122 of the semiconductor die 120 and may be electrically coupled to at least a first part of first surface 108 of the metallic sheet 104. A second load electrode and a control electrode may be arranged on the front side 124 of the semiconductor die 120 and may be electrically coupled to a second part of the first surface 108 of the metallic sheet 104 by bond wires, bond ribbons or clips etc.

In some examples, further semiconductor dies 120 may be arranged on the first surface 108 of the metallic sheet 104. The semiconductor dies 120 may be coupled to form any suitable electrical circuit, e.g. a converter circuit.

Figure 1C shows arranging 105 an electrically insulative housing 126 above the first surface 108 of the substrate 102. The electrically insulative housing 126 may comprise a polymeric material, e.g. a thermoset material or a thermoplastic material. The polymeric material may be a dispensed material. The polymeric material may have a glass transition temperature around or below 220 C or 260 C. At the glass transition temperature, the polymeric material becomes soft and can be easily molded. Upon cooling, the polymeric material becomes hard again. The electrically insulative housing 126 has a circumferential frame 128 arranged above an outer edge 130 of the metallic sheet 104. The circumferential frame 128 forms a joining section 132 with the metallic sheet 104 at a lower end 134 of the circumferential frame 128 facing the first surface 108 of the metallic sheet 104.The surfaces 112 and 114 of electrically insulative sheet 106 are rough. Optionally, the lower end 134 of the circumferential frame 128 may also be in contact with an outer exposed part 136 of the front side 112 of the electrically insulating sheet 106 forming a further joining section between frame and electrically insulating sheet 106. The joining sections may extend along a circumference of the circumferential frame 128 in a direction parallel to the first surface 108 of the metallic sheet 104.

The circumferential frame 128 comprises an electrically inducible element 138 near the joining section 132 of the circumferential frame 128. The electrically inducible element 138 is completely surrounded by the electrically insulative housing 126 in all directions and is preferably uniformly distributed along the circumference of the circumferential frame 128. The joining section 132 may be configured to be heated up to the glass transition temperature of the electrically insulative housing 126 by inductively heating the electrically inducible element 138. To inductively heat up the joining section 132 of the circumferential frame 128 an electromagnetic field with a frequency of 0.5 GHz to 2 GHz or 1 GHz to 3GHz may be used. The joining section 132 may be heated without heating the whole circumferential frame 128.

The electrically inducible element 138 may comprise an electrically conducting material e.g., a metal which is suitable for induction heating such as but not limited to copper, aluminum, nickel, an alloy or graphite, steel, stainless steel, silicon carbide or titanium etc. The metal may be magnetic e.g., steel or stainless steel or non-magnetic e.g., aluminum, magnesium, titanium etc. The metal is a thermally conductive metal. The electrically inducible element 138 may be a ceramic e.g., alumina or zirconia or a polymer e.g., polyvinyl chloride (PVC) and polyethylene terephthalate (PET) or a ferrite e.g., manganese-zinc ferrite (MnZn) and nickel-zinc ferrite (NiZn) or composite material e.g., metal-ceramic composite or magneto-dielectric material

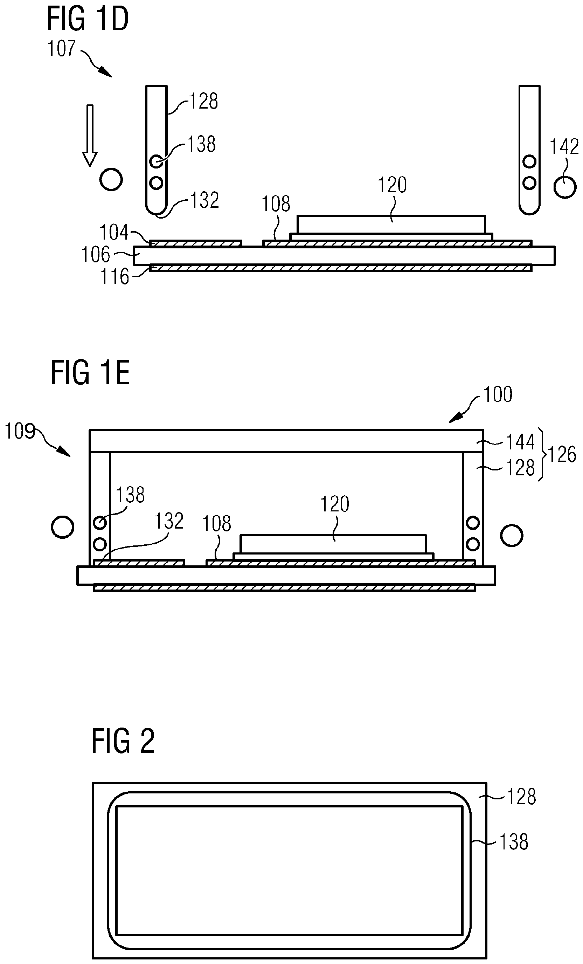

The electrically inducible element 138 may have a continuous form such as a wire or a sheet clamped along the circumference of the circumferential frame 128 as shown in Figure 2, which is a cross-section of the circumferential frame 128 in the direction parallel to the first surface 108 of the metallic sheet 104. The electrically inducible element 138 may be looped along the circumference of the circumferential frame 128 more than once. Alternatively, the electrically inducible element 138 may comprise more than one wire or sheet looped along the circumference of the circumferential frame 128.

In order to inductively heat 107, the joining section 132 of the circumferential frame 128 an induction loop 142 is arranged around the circumference of the circumferential frame 128 as indicated in Figure 1D. The induction loop 142 is arranged outside the circumferential frame 128 and comprise a metallic rod or a metallic wire suitable for carrying an alternate current (AC). When the AC current is passed through the induction loop 142, a time varying electromagnetic field within and around the induction loop 142 is generated. The electromagnetic field penetrates the circumferential frame 128. The penetrating electromagnetic field induces an eddy current in the electrically inducible element 138 of the circumferential frame 128. The eddy current is dissipated in form of heat. As the electrically inducible element 138 is surrounded by the electrically insulative housing 126 in all directions, therefore the heat is transferred to the circumferential frame 128 from the electrically inducible element 138. The joining section 132 of the circumferential frame 128 may be heated above the glass phase transition temperature of the electrically insulative housing 126. Therefore, the joining section 132 becomes malleable.

After the joining section 132 of the circumferential frame 128 has become malleable, the circumferential frame 128 is pressed 109 onto the substrate 102 as shown in Figure 1E. More particular, the circumferential frame 128 is pressed onto the first surface 108 of the metallic sheet 104 wherein a direct joint as a thermoplastic bond is formed between the metallic sheet 104 and the joining section 132 of the circumferential frame 128. In particular, the thermoplastic bond is formed between the first surface 108 of the metallic sheet 104 and the joining section 132 of the circumferential frame 128. Furthermore, the joining section of the circumferential frame 128 may overlap with the outer edges 130 of the metallic sheet 104. Therefore, another thermoplastic bond may also be formed between the outer edges 130 of the metallic sheet 104 and the joining section 132 of the circumferential frame 128. Upon cooling, the joining section 132 hardens and is thus locked into the metallic sheet 104 of the substrate by the thermoplastic bond.

The electrically insulative housing 126 further comprises a lid 144 which is arranged on the upper ends 140 of the circumferential frame 128 to close the electrically insulative housing 126. Thus, the semiconductor die 120 is completely enclosed inside the electrically insulative housing 126.

The method disclosed in Figures 1A-1E allows the formation of a direct joint between the circumferential frame 128 and the substrate as a thermoplastic bond without heating the substrate 102. Consequently, thermally induced damages to the electrically conductive layer 118 on the substrate 102 can be avoided. The electrically conductive layer 118 will not heat up during pressing 109 and therefore the risk of tilting the semiconductor die 120 with respect to the metallic sheet 104 may be reduced.

The semiconductor module 100 may further comprise an electrical terminal mounted on the first surface 108 of the metallic sheet 104 (not shown). The electrical terminal may extend out of the housing 126 in the direction lateral to the first surface 108 of the metallic sheet 104. Only a part of the electrical terminal overlapping with the substrate 102 may be surrounded by the electrically insulative housing 126 and the rest of the electrical terminal protrudes from the electrically insulative housing 126.

The electrically insulative housing 126 may be filled with a potting compound (not shown). The potting compound may consist of or include a silicone gel or may be a rigid molding compound, for example. The potting compound may cover the metallic sheet 104 of the substrate 102 and the semiconductor die 120.

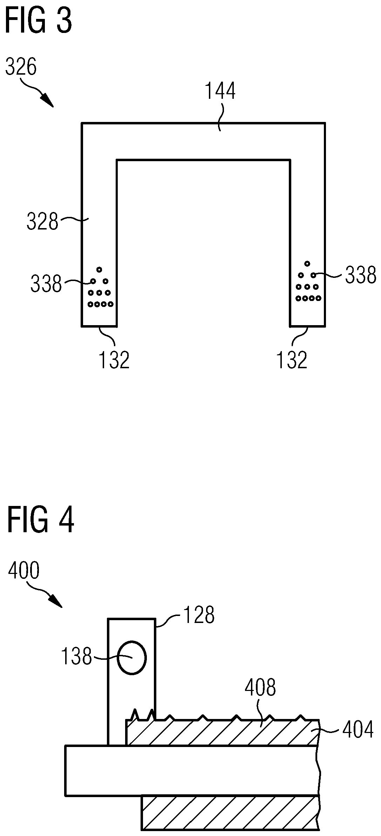

Figure 3 shows an alternate example of an electrically insulative housing 326 which can be used in the method described in Figures 1A-1E. The electrically insulative housing 326 may include some or all features of the electrically insulative housing 126 of Figures 1C-1E. The electrically inducible element 338 in the circumferential frame 128 is a discontinuous metal arranged along the circumference of the circumferential frame 128. The discontinuous metal may comprise pieces of the metal 138, such as metal flakes or powder in form of filler particles. The electrically inducible element 338 may comprise a fiber composite e.g., a carbon fiber or nano tubes distributed uniformly along the circumference of the circumferential frame 328. The carbon fiber has low thermal expansion, i.e. carbon fiber does not expand much upon heating. Further, the carbon fiber has high chemical resistance, i.e. carbon fiber can be safely used in the electrically insulative housing 326 without being reactive towards the electrically insulative housing 326. The fiber composite may be injected into the circumferential frame 128 during injection molding of the circumferential frame 328. The fiber composite may be melted before injecting into the circumferential frame 328, such that the fiber composites are integrated into the circumferential frame 328.

Instead of carbon fibers, the electrically inducible element 338 may be a filler particle in particular, an electrically conducting filler particle. Further, the electrically conducting filler particle may be a magnetic filler particle. The electrically conducting filler particles may comprise metal oxides, metal nitrides or doped semiconductor materials etc. A particle size of the filler particle may be less than 100 µm. Alternatively or in combination, the maximum dimension in all space directions of each of the filler particle is less than 100 µm. The electrically conducting filler particle may be a nano filler particle e.g., silica or alumina. The fiber composites may be milled and used as filler particles.

A concentration of the electrically inducible element 338 may be non-uniform e.g., may increase toward the joining section 132 of the circumferential frame 128. The concentration may be defined as a volume density e.g., a mass of the electrically inducible element 338 per unit volume or as a number density e.g., a number of the electrically inducible element 338 per unit volume or per unit area. The non-uniform distribution of the electrically inducible element 338 may allow heating of the joining section 132 efficiently without heating the rest of the circumferential frame 328.

Figure 4 shows a cross-section of an outer edge of a semiconductor module 400. The semiconductor module 400 may include some or all features of the semiconductor module 100 of Figure 1E. A first part of the first surface 408 of the metallic sheet 404 of the semiconductor module 400 facing the circumferential frame 128 is rougher than other part of the first surface 408 of the metallic sheet 404 exposed from the circumferential frame 128. The first part of the first surface 408 of the metallic sheet 404 may comprise a roughened surface texture and/or a plurality of micro holes and/or a ridge and/or a furrow, in particular a part of the first surface 408 of the metallic sheet 404 below the joining section 132 of the circumferential frame 128.

The roughness of the first surface 408 of the metal sheet may increase the strength of the thermoplastic bond between the circumferential frame 128 and the metallic sheet 404. The roughness of the first surface 408 of the metallic sheet 404 may e.g. be defined by a profile roughness parameter Ra. The surface roughness parameter Ra of the first part of the first surface 408 of the metallic sheet 404 may e.g. be two times, three times, four times, five times, ten times or even more greater than the surface roughness parameter Ra of the other part of the first surface 408 of the metallic sheet 404. The first surface 408 of the metallic sheet 404 may be pre-treated with a laser in order to roughen the first surface 408 of the metallic sheet 404.

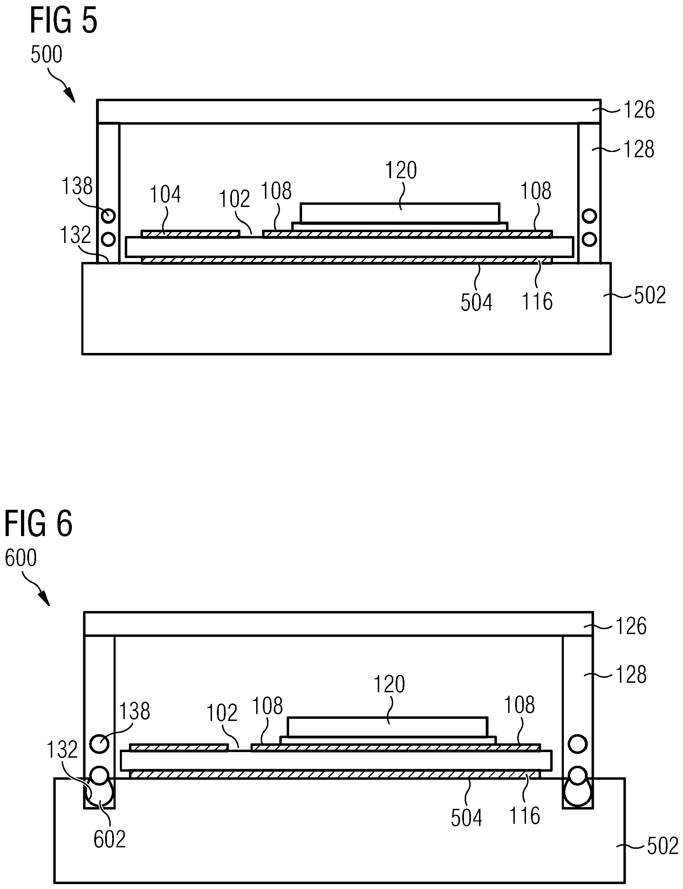

Figure 5 shows a further example of a semiconductor module 500. The semiconductor module 500 may include some or all features of the semiconductor module 100 of Figure 1E. The electrically insulative housing 126 is arranged on a metal baseplate 502 instead of the substrate 102. The metal baseplate 502 is arranged on the metallic sheet 116 of the substrate 102 and is used for dissipating heat from the semiconductor module 500. The metal baseplate 502 may be glued e.g., by a thermally conductive adhesive or sintered onto the metallic sheet 116 of the substrate 102. The metal baseplate 502 extends beyond the substrate 102 in the direction parallel to the first surface 108 of the metallic sheet 104. The electrically insulative housing 126 is arranged on a first surface 504 of the metal baseplate 502 facing the substrate 102 such that the substrate 102 and the semiconductor die 120 are enclosed inside the electrically insulative housing 126. The joining section 132 of the circumferential frame 128 is directly joined to the first surface 504 of the metal baseplate 502 and a thermoplastic bond is formed between the joining section 132 of the circumferential frame 128 and the first surface 504 of the baseplate 502.

In some examples, the first surface 504 of the metal baseplate 502 may be roughened analogue to the metallic sheet 404 of Figure 4.

Figure 6 shows a further example of a semiconductor module 600. The semiconductor module 600 may include some or all features of the semiconductor module 500 of Figure 5. The metal baseplate 502 comprises a groove 602 on the first surface 504 of the metal baseplate 502. The groove 602 may have a varying width measured in the direction parallel to the first surface 504 of the metal baseplate 502. The width of the groove may decrease towards the first surface 504 of the metal baseplate 502. When the joining section 132 is pressed onto first surface 504 of the metal baseplate 502, the joining section 132 fills the groove 602. The joining section 132 further forms a thermoplastic bond with a surface of the groove 602 as described herein above. Upon cooling, the joining section 132 solidifies in the groove 602. Due to the decreasing width of the groove 602, the circumferential frame 128 is locked into the groove 602. This may provide further stability to the housing 126 on the metal baseplate 502. The metal baseplate 502 shown in Figure 6, has two grooves on opposing sides of the metal baseplate. However, the metal baseplate 502 may have more than two grooves 602 on the first surface 504 of the metal baseplate 502. Instead of grooves 602, the metal baseplate may also comprise trenches.

Alternatively, the metal baseplate 502 may comprise a dome structure protruding from the first surface 504 of the metal baseplate 502. When the joining section 132 is pressed onto first surface 504 of the metal baseplate 502, the joining section 132 forms a further thermoplastic bond with the dome structure.

The semiconductor module described herein includes one or more semiconductor dies. In particular, one or more semiconductor dies may be involved. More specifically, semiconductor dies may, for example, be configured as power MISFETs (Metal Insulator Semiconductor Field Effect Transistors), power MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors), power bipolar transistors or power diodes such as, e.g., PIN diodes or Schottky diodes.

The semiconductor dies may be manufactured from specific semiconductor material such as, for example, Si, SiC, SiGe, GaAs, GaN, AlGaN, InGaAs, InAIAs, etc., and, furthermore, may contain inorganic and/or organic materials that are not semiconductors. The semiconductor dies may be of different types and may be manufactured by different technologies.

The semiconductor module described herein include a substrate comprising an insulating layer sandwiched between metallic sheets. The metallic sheets may be made of any metal or metal alloy, e.g. copper or copper alloy. The substrate may include a sheet of ceramics coated with a metallic sheet, e.g. a metal bonded ceramics substrate. By way of example, the substrate may be a DCB (direct copper bonded) ceramics substrate or AMB (active metal brazed) ceramics substrate.

The semiconductor module described herein includes electrical terminals. The electrical terminals may be connected to a load electrode and a control electrode of the semiconductor die via a routing structure of the substrate. The electrical terminals may protrude from a circumferential frame and/or from a lid of an electrical insulative housing i.e. the electrical terminals may be partially enclosed by the electrically insulative housing. The electrical terminal may be made of any metal or metal alloy, in particular of metals having high electrical conductivity. By way of example, the electrical terminal may comprise or may be made of copper or a copper alloy.

The semiconductor module may further include a casting compound encapsulating the semiconductor die and a part of the metallic sheet of the substrate. The casting compound may consist of or include a silicone gel or may be a rigid molding compound, for example.

### Further examples:

Example 1 discloses a method for forming a direct joint between a metallic sheet and an electrically insulative housing of a semiconductor module, the method comprising: arranging the electrically insulative housing comprising a circumferential frame above a first surface of the metallic sheet, wherein an electrically inducible element is enclosed near a joining section of the circumferential frame, inductively heating the electrically inducible element in the circumferential frame such that the joining section of the circumferential frame is heated above a glass transition temperature, and pressing the joining section of the circumferential frame onto the first surface of the metallic sheet such that a direct joint between the first surface of the metallic sheet and the joining section of the circumferential frame is formed.

Example 2 discloses the method according to example 1, further comprising roughening the first surface of the metallic sheet, wherein parts of the first surface of the metallic sheet facing the joining section of the circumferential frame has a roughness value Ra at least two times larger than a roughness value Ra of a rest of the first surface of the metallic sheet.

Example 3 discloses the method according to example 1 or 2, further comprising: forming a groove on the first surface of the metallic sheet, wherein pressing the joining section of the circumferential frame onto the first surface of the metallic sheet comprises pressing the joining section of the circumferential frame into the groove.

Example 4 discloses the method according to any of examples 1 to 3, wherein inductively heating the electrically inducible element further comprises arranging an induction loop outside circumferential frame to induce an electric current in the electrically inducible element.

Example 5 discloses a semiconductor module comprising: a metallic sheet comprising a first surface, a semiconductor die coupled to the first surface of the metallic sheet, an electrically insulative housing comprising a circumferential frame, wherein the electrically insulative housing encloses the semiconductor die and at least a part of the first surface of the metallic sheet, wherein a joining section of the circumferential frame is directly joined to the first surface of the metallic sheet, wherein an electrically inducible element is enclosed near the joining section of the circumferential frame.

Example 6 discloses the semiconductor module according to example 5, wherein the electrically inducible element comprises a metal.

Example 7 discloses the semiconductor module according to example 5, wherein the electrically inducible element comprises a fiber composite.

Example 8 discloses the semiconductor module according to any of the preceding examples from 5 to 7, wherein the electrically inducible element is a wire or sheet enclosed in the joining section.

Example 9 discloses the semiconductor module according to any of the preceding examples from 5 to 7, wherein the electrically inducible element consists of filler particles distributed in the joining section circumferential frame.

Example 10 discloses the semiconductor module according to any of the preceding examples from 5 to 9, wherein the electrically inducible element is uniformly distributed along a circumference of the circumferential frame.

Example 11 discloses the semiconductor module according to any of the preceding examples from 5 to 10, wherein a concentration of the electrically inducible element increases towards the joining section of the circumferential frame.

## Claims

1. A method for forming a direct joint between a metallic sheet (104, 404, 502) and an electrically insulative housing (126, 326) of a semiconductor module (100, 400, 500, 600), the method comprising:
arranging (105) the electrically insulative housing (126, 326) above a first surface (108, 408, 504) of the metallic sheet (104, 404, 502), the electrically insulative housing (126, 326) comprising a circumferential frame (128, 328);
wherein an electrically inducible element (138, 338) is enclosed near a joining section (132) of the circumferential frame (128, 328),
inductively heating (107) the electrically inducible element (138, 338) in the circumferential frame (128, 328) such that the joining section (132) of the circumferential frame (128, 328) is heated above a glass transition temperature, and
pressing (109) the joining section (132) of the circumferential frame (128, 328) onto the first surface (108, 408, 504) of the metallic sheet (104, 404, 502) such that a direct joint between the first surface (108, 408, 504) of the metallic sheet (104, 404, 502) and the joining section (132) of the circumferential frame (128, 328) is formed.

2. The method according to claim 1, further comprising roughening the first surface (408) of the metallic sheet (404), such that parts of the first surface (408) of the metallic sheet (404) facing the joining section (132) of the circumferential frame (128, 328) has a roughness value Ra at least two times larger than a roughness value Ra of a rest of the first surface (408) of the metallic sheet (404).

3. The method according to claim 1 or 2, further comprising:
forming a groove (602) on the first surface (504) of the metallic sheet (502), wherein pressing the joining section (132) of the circumferential frame (128, 328) onto the first surface (504) of the metallic sheet (502) comprises pressing the joining section (132) of the circumferential frame (128, 328) into the groove (602).

4. The method according to any of claims 1 to 3, wherein inductively heating (107) the electrically inducible element (138, 338) further comprises arranging an induction loop (142) outside circumferential frame (128, 328) to induce an electric current in the electrically inducible element (138, 338).

5. A semiconductor module (100, 400, 500, 600) comprising:
a metallic sheet (104, 404, 502) comprising a first surface (108, 408, 504),
a semiconductor die (120) coupled to the first surface (108, 408, 504) of the metallic sheet (104, 404, 502),
an electrically insulative housing (126, 326) comprising a circumferential frame (128, 328), wherein the electrically insulative housing (126, 326) encloses the semiconductor die (120) and at least a part of to the first surface (108, 408, 504) of the metallic sheet (104, 404, 502),
wherein a joining section (132) of the circumferential frame (128, 328) is directly joined to the first surface (108, 408, 504) of the metallic sheet (104, 404, 502),
wherein an electrically inducible element (138, 338) is enclosed near the joining section (132) of the circumferential frame (128, 328).

6. The semiconductor module (100, 400, 500, 600) according to claim 5, wherein the electrically inducible element (138, 338) comprises a metal.

7. The semiconductor module (100, 400, 500, 600) according to claim 5, wherein the electrically inducible element (138, 338) comprises a fiber composite.

8. The semiconductor module (100, 400, 500, 600) according to any of claims 5 to 7, wherein the electrically inducible element (138, 338) is a wire or sheet enclosed in the joining section (132).

9. The semiconductor module (100, 400, 500, 600) according to any of claims 5 to 7, wherein the electrically inducible element (138, 338) consists of filler particles distributed in the joining section (132) circumferential frame (128, 328).

10. The semiconductor module (100, 400, 500, 600) according to any of claims 5 to 9, wherein the electrically inducible element (138, 338) is uniformly distributed along a circumference of the circumferential frame (128, 328).

11. The semiconductor module (100, 400, 500, 600) according to any of claims 5 to 10, wherein a concentration of the electrically inducible element (138, 338) increases towards the joining section (132) of the circumferential frame (128, 328).
